(19) **Europäisches Patentamt / European Patent Office / Office européen des brevets**

(11) **EP 1 811 650 A1**

(12) **EUROPEAN PATENT APPLICATION**

(43) Date of publication:
**25.07.2007 Bulletin 2007/30**

(51) Int Cl.:
**H03D 7/16** (2006.01)

(21) Application number: **06290067.5**

(22) Date of filing: **10.01.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Alcatel Lucent**
**75008 Paris (FR)**

(72) Inventors:
• **Schlesinger, Heinz, Dipl.- Ing**
  **74395 Mundelsheim (DE)**
• **Weiss, Ulrich, Dipl.-Ing.**
  **73035 Göppingen (DE)**

(74) Representative: **Richardt, Markus Albert**
  **Leergasse 11**
  **65343 Eltville (DE)**

(54) **Method for finely tuning the frequency of a radio signal**

(57) The invention relates to a method for converting a digital baseband signal into an a-nalogue RF signal or vice versa.

If a digital baseband signal is converted into an analogue RF signal the phase noise and spurious emissions are limiting factors as far as the signal quality is concerned.

It is an object to achieve a signal with low phase noise and no spurious emissions.

It is suggested to convert the signal in the digital domain by a complex modulator and in the analogue domain by an I/Q modulator. As an example, the frequency step size of an NCO driving the complex modulator may be chosen to be smaller than the frequency step size of an LO driving the I/Q modulator.

Fig. 2

**Description**

**Field of the invention**

The invention relates to the field of telecommunication, and more particularly to oscillator components in telecommunication systems.

**Background and prior art**

In the framework of wireless telecommunications, and in particular digital wireless communication systems, a baseband signal carrying information has to be modulated to a radio frequency (RF) band prior to broadcasting it into free space.

The RF band has a predefined bandwidth, e.g. 60 MHz in the case of UMTS. Depending on the broadcasting standard the base stations and users may be distinguished by different radio frequencies. In the case of UMTS the channel width is 5 MHz, and the channels have to be placed within a channel raster of 200 kHz. As a consequence, a transmitter or a receiver must be able to tune the frequency in steps of 200 kHz.

It is known to use an integer-N PLL synthesizer for the above-mentioned purposes. The integer-N PLL synthesizer provides a good signal quality, albeit with a high phase noise.

It is further known to substitute the above-mentioned integer-N PLL synthesizer by a fractional-N PLL synthesizer to reduce the phase noise. However, a fractional-N PLL synthesizer shows spurious emissions such that the overall signal quality is worse than in the case of an integer-N PLL.

**Summary of the invention**

It is an object of the invention to provide a method for converting a digital baseband signal into a finely tuned analogue RF signal, whereby the RF signal has a high signal quality. Furthermore, it is an object to provide a method with which an analogue RF signal can be converted into a high-quality digital baseband signal.

This object and other objects are solved by the features of the independent claims. Preferred embodiments of the invention are described by the features of the dependent claims. It should be emphasized that any reference signs in the claims shall not be construed as limiting the scope of the invention.

According to a first aspect of the invention a method for converting a digital baseband signal into an analogue RF signal is provided. This method is carried out with a device which will be called up-converter within this description. The up-converter can be an I/Q modulator and a mixer or, as it will be described in the following, a complex modulator and an I/Q modulator. For sake of brevity only the latter possibility will be described in more detail below.

The up-converter comprises a complex modulator for modulating the digital baseband signal into an intermediate digital baseband signal (low IF-signal; IF=intermediate frequency). The input of the modulator is thus the in-phase signal I and the quadrature component Q of the baseband signal, and its output is a modulated in-phase signal $I_1$ and a modulated quadrature component $Q_1$. The modulator is a complex modulator working in the digital domain. It shifts the frequency spectrum of the baseband signal to a frequency called the intermediate frequency.

The output signals of the complex modulator are transferred into analogue signals by means of digital-to-analogue converters.

The analogue signals are then inputted into an I/Q modulator. This I/Q modulator works in the analogue domain and mixes the analogue signals with a frequency provided by a local oscillator. The output of the I/Q modulator is then the output of the up-converter.

The frequency of the output signal is the sum of the intermediate frequency feeding the complex modulator and of the LO frequency feeding the I/Q modulator:

$$f_{RF\,signal} = f_{Complex\ Modulator} + f_{I/Q\,Modulator} \qquad \text{(equation 1)}$$

The frequency $f_{Complex\,Modulator}$ which feeds the complex modulator is adjusted with a smaller frequency step size than the frequency $f_{I/Q\,Modulator}$ which feeds the analogue I/Q modulator. This has the consequence that the precise adjustment of $f_{Complex\,Modulator}$ is responsible for finely tuning the frequency of the analogue RF signal with frequency $f_{RF\,signal}$. Correspondingly, the coarse adjustment of $f_{I/Q\,Modulator}$ is responsible for coarsely tuning the frequency of the analogue RF signal. As a result the analogue RF signal is finely tuned, whereby the stepping of the tuning of the up-converter is determined by the the frequency step size chosen for adjusting the frequency $f_{Complex\,Modulator}$ feeding the complex modulator.

An advantage associated with this embodiment is that the signal quality is very good. The signal has a particularly low phase noise and has no spurious emissions. The reason is that the embodiment reduces the requirements for adjusting the frequency in the I/Q modulator. This leads to less phase noise in the local oscillator feeding the I/Q modulator and thus improves the signal quality of the output signal. This is particularly true when the I/Q modulator is driven by an integer PLL working with large frequency steps.

In numerical terms the above-mentioned advantage depends on the choice of the local oscillator being part of the I/Q modulator, such that this advantage shall be further explained by assuming that the local oscillator is an Integer-N PLL. If the frequency of the output is 2170 MHz and if a frequency stepping of 200 kHz is desired, the frequency range of 2170 MHz is divided 2170 MHz / 200 kHz = 10.850. This will lead to a degradation in the phase noise of 20 dB * log (10.850) = 80.7 dB inside the PLL loop bandwidth. The signal quality of the Integer-N PLL can be regarded to be good as it has no spurious emissions in contrast to fractional-N PLL's. With the present invention the frequency stepping in the analogue domain can be made wider, e.g. 30 MHz, as a fine tuning of the frequency can be established in the complex modulator. With steps of 30 MHz the degradation of the phase noise is only 20 dB * log (72.3) = 37.2 dB which amounts to an improvement of 43.5 dB in the phase noise without a deterioration of the signal quality.

It is also possible to modify the steps of the above embodiment and to do the steps of the above embodiment in reverse order, such that a down-conversion is carried out. In this way analogue RF signals are converted into a digital baseband signal. In this second aspect of the invention the RF signal is, as a first step, mixed with the (analogue) signal provided by a local oscillator. The resulting signal is then converted into a digital signal. In the digital domain the frequency spectrum is shifted from an intermediate frequency to baseband. Thereby, a digital baseband signal of high quality is obtained.

As in the first embodiment, the frequency step size in the digital domain is chosen to be smaller than the frequency step size in the analogue domain. This means that the mixing carried out in the I/Q modulator coarsely tunes the frequency of the baseband signal, and that the shifting in the complex modulator finely tunes the frequency of the baseband signal.

The output frequency of the up-converter may be in the GHz region, and is preferably between about 0.4 GHz and about 5 GHz. The RF output signal can then be used by transmitters and receivers for wireless communication systems such as GSM systems, UMTS systems, WiMAX systems or the like.

The method according to claim 2 can be used by an electronic receiver to receive analogue RF signals and to convert them into a digital baseband signal. Correspondingly, the method of claim 1 can be used by an electronic transmitter processing digital baseband signals and transmitting them as analogue RF signals over the air interface. The receiver and the transmitter may be part of a base station of a wireless telecommunication system, e.g. a cellular system, or of a terminal device serviced by a base station of such a telecommunication system. The terminal device may be a mobile terminal device such as a mobile phone, a laptop, a notebook, a digital portable assistant (PDA) or other suitable electronic devices which can be serviced by a base station in a wireless fashion.

The oscillator feeding the complex modulator can be implemented as a NCO (numerically controlled oscillator) or as a CORDIC module. With a CORDIC module the accuracy can be arbitrarily accurate. The local oscillator feeding the analogue I/Q modulator can be implemented as an Integer-N PLL.

These and other aspects of the invention will be apparent from and elucidated with reference to the embodiments thereafter. It should be noted that the use of reference signs shall not be construed as limiting the scope of the invention.

**Brief description of the drawings**

Fig. 1    shows an up-converter for converting a digital baseband signal into an analogue signal according to an embodiment of the invention,

Fig. 2    shows a flowchart illustrating the way in which a digital baseband signal is, with the help of the device according to Fig. 1, converted into an analogue RF signal,

Fig. 3    shows a flowchart illustrating the way in which an analogue RF signal is, with the help of the device according to Fig. 1, converted into a digital baseband signal.

**Detailed description of the drawing**

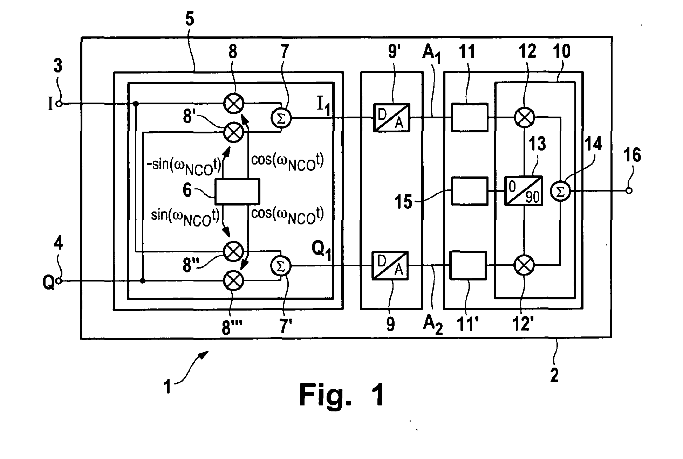

Fig. 1 shows an embodiment of an up-converter 1 within a TX-frontend 2. On the lefthand side input ports 3 and 4 serve to input the in-phase signal I and the quadrature component Q of the digital baseband signal. The I signal and the Q signal serve as an input for the complex modulator 5. The complex modulator 5 comprises a NCO 6, two adders 7, 7' and four mixers 8, 8', 8" and 8'". The complex modulator 5 shifts the digital frequency spectrum of the complex input signal by a fixed frequency set in the NCO 6. The functioning of this complex modulator is well known to the man skilled in the art and thus not discussed any further.

The output $I_1$ and $Q_1$ of complex modulator 5 are inputted into two digital-to-analogue converters 9 and 9' respectively.

The corresponding analogue signals $A_1$ and $A_2$ are transferred as an input for the analogue I/Q modulator 10 after passing low pass filters 11 and 11' respectively. I/Q modulator has two mixers 12 and 12', a phase shifter 13 and an adder 14. The functioning of the analogue I/Q modulator 10 is known to the man skilled in the art and thus does not need further explanation. Analogue I/Q modulator 10 mixes complex analogue signals $A_1$ and $A_2$ with the radio frequency of a local oscillator 15. The local oscillator may be a Integer-N PLL, and may provide a frequency in the range of of 0.4 GHz to 5 GHz.

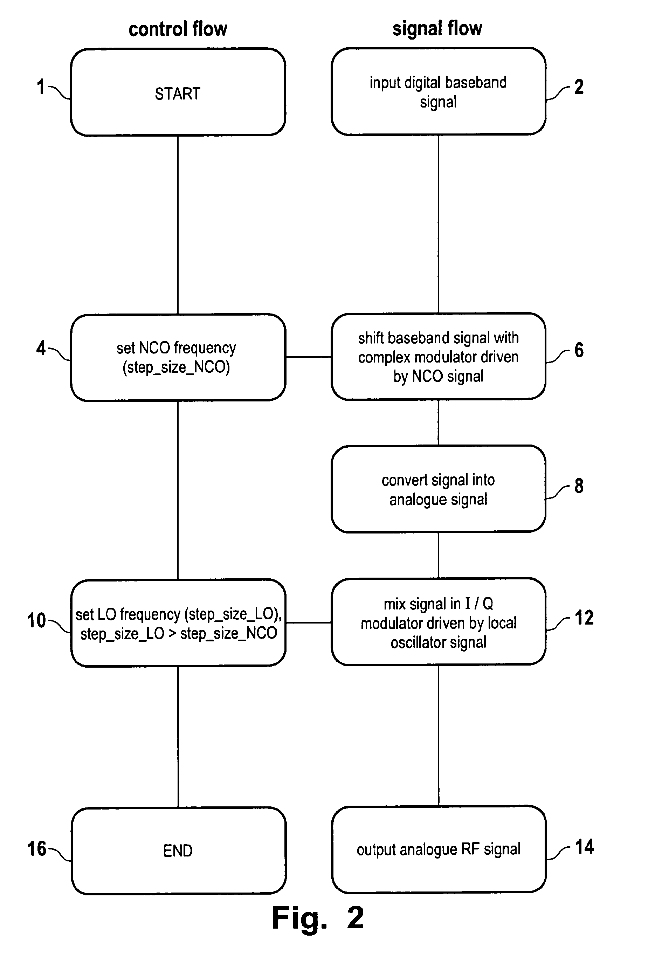

Fig. 2 shows a flowchart illustrating the way in which a digital baseband signal is converted into an analogue RF signal, and the processing of the signal flow by the up-converter 1 of Fig. 1. The method starts with step 1. In step 2 a digital baseband signal is inputted into the device. In step 4 the frequency step size of the NCO 6 driving the complex modulator 5 is chosen. This frequency step size is called step_size_NCO. In step 6 the frequency of the digital baseband signal is shifted with complex modulator 5, whereby the complex modulator 5 is driven by the signal outputted by NCO 6. In step 8 the intermediate signal is converted into the analogue domain by means of digital-to-analogue converters 9, 9'.

In the analogue domain the frequency step size of the LO 15 is set in step 10. This frequency step size is called step_size_LO and is chosen to be larger than step_size_NCO. Hence step_size_LO > step_size_NCO. In step 12 the analogue signals $A_1$, $A_2$ are mixed with the signal of LO 15. This is done in analogue I/Q modulator 10. In step 14 an analogue RF signal is outputted at port 16, such that the method ends with step 16.

Steps 2, 6, 8, 12, 14 are steps carried out by the device according to Fig. 1 when processing the signal flow. Steps 4 and 10 are settings decided upon by the user of the up-converter, and are in many cases adjusted only once. As a matter of fact, the settings in steps 4 and 10 can each be carried out earlier than just described.

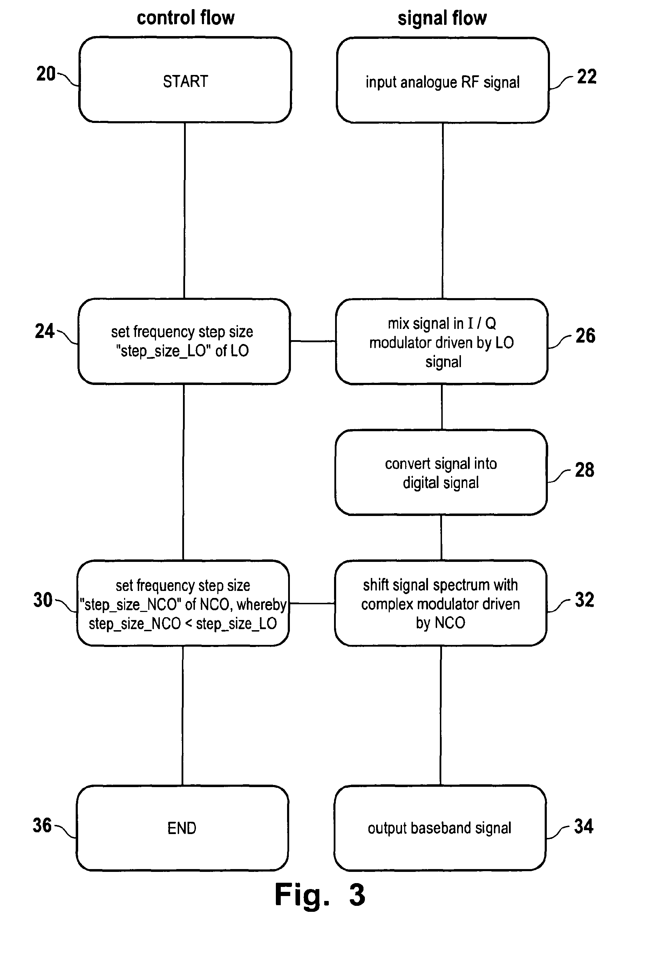

Fig. 3 shows a flowchart illustrating the way in which an analogue RF signal is converted into a digital baseband signal. In step 22 an analogue RF signal is inputted. In step 24 the frequency step size of an LO driving an I/Q demodulator is chosen. This frequency step size is called step_size_LO. In step 26 the received RF signal is mixed with the signal provided by the LO In step 28 the signal thus obtained is converted into the digital domain by means of two analogue-to-digital converters.

In the digital domain the frequency step size of an NCO is set in step 30. This frequency step size is called step_size_NCO and is chosen to be smaller than step_size_LO. Hence step_size_LO > step_size_NCO. In step 32 the digital signals are shifted with the signal provided by the NCO. This is done in a complex modulator with a frequency step size step_size_NCO. In step 34 a digital baseband signal is outputted such that the method ends with step 36.

Steps 22, 26, 28, 32, 34 are steps carried out by the down-converter when processing the signal flow. Steps 24 and 30 are settings decided upon by the user of the up-converter, and are in many cases adjusted only once. As a matter of fact, the settings in steps 24 and 30 can each be carried out earlier than just described.

**List of reference numerals**

| | |
|---|---|
| 01 | Up-converter |
| 02 | TX-frontend |
| 03 | Input port |
| 04 | Input port |
| 05 | Complex modulator |
| 06 | NCO |
| 07 | Adder |
| 07' | Adder |
| 08 | Mixer |
| 08' | Mixer |
| 08" | Mixer |
| 08''' | Mixer |
| 09 | DAC |
| 09' | DAC |
| 10 | I/Q modulator |
| 11 | Low pass filter |
| 11' | Low pass filter |
| 12 | Mixer |

| 12' | Mixer |
| 13 | 90° phase shifter |
| 14 | Adder |
| 15 | Local oscillator |
| 16 | Output port |

**Claims**

1. Method of finely tuning the frequency of an analogue radio frequency (RF) signal, the method comprising the following steps:

   a) shifting the frequency of a baseband signal to an intermediate frequency,
   b) converting the resulting signal into an analogue signal,
   c) mixing the analogue signal with a signal provided by a local oscillator (LO), thereby obtaining the RF signal,
   d) whereby the frequency step size in step a) is chosen to be smaller than the frequency step size in step c).

2. Method of finely tuning a radio frequency (RF) signal to a digital baseband signal, the method comprising the following steps:

   a) mixing an analogue RF signal with the signal provided by a local oscillator,
   b) converting the resulting signal into a digital signal,
   c) shifting the frequency of the digital signal from an intermediate frequency to baseband,
   d) whereby the frequency step size in step c) is chosen to be smaller than the frequency step size in step a).

3. Method according to claim 1 or 2, wherein the step size of the intermediate frequency is chosen to be smaller than the frequency step size of the LO.

4. Method according to claim 3, wherein the step size of the intermediate frequency is in the kHz region, and whereby the step size of the frequency provided by the local oscillator is in the MHz region.

**Fig. 1**

**control flow**

**signal flow**

1 — START

2 — input digital baseband signal

4 — set NCO frequency (step_size_NCO)

6 — shift baseband signal with complex modulator driven by NCO signal

8 — convert signal into analogue signal

10 — set LO frequency (step_size_LO), step_size_LO > step_size_NCO

12 — mix signal in I / Q modulator driven by local oscillator signal

16 — END

14 — output analogue RF signal

# Fig. 2

**control flow**

**signal flow**

20 — START

22 — input analogue RF signal

24 — set frequency step size "step_size_LO" of LO

26 — mix signal in I / Q modulator driven by LO signal

28 — convert signal into digital signal

30 — set frequency step size "step_size_NCO" of NCO, whereby step_size_NCO < step_size_LO

32 — shift signal spectrum with complex modulator driven by NCO

36 — END

34 — output baseband signal

# Fig. 3

European Patent Office

# EUROPEAN SEARCH REPORT

Application Number

EP 06 29 0067

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/150169 A1 (KISHI TAKAHIKO) 17 October 2002 (2002-10-17) * paragraph [0080] - paragraph [0102]; claim 1; figure 1 * ----- | 1,3,4 | INV. H03D7/16 |
| Y | US 2002/048325 A1 (TAKAHIKO KISHI) 25 April 2002 (2002-04-25) * paragraph [0018] - paragraph [0021]; claim 1; figure 3 * ----- | 2-4 | |
| Y | US 5 548 244 A (CLEWER ET AL) 20 August 1996 (1996-08-20) * column 2, line 53 - column 4, line 30; figures 1,2 * ----- | 2-4 | |
| A | EP 1 213 830 A (MOTOROLA, INC) 12 June 2002 (2002-06-12) * paragraph [0018] - paragraph [0034]; figure 3 * ----- | 2-4 | |
| A | CROLS J ET AL: "A SINGLE-CHIP 900 MHZ CMOS RECEIVER FRONT-END WITH A HIGH PERFORMANCE LOW-IF TOPOLOGY" IEEE JOURNAL OF SOLID-STATE CIRCUITS, IEEE SERVICE CENTER, PISCATAWAY, NJ, US, vol. 30, no. 12, December 1995 (1995-12), pages 1483-1492, XP000557254 ISSN: 0018-9200 * figure 11 * ----- | 2-4 | TECHNICAL FIELDS SEARCHED (IPC) H03D |

The present search report has been drawn up for all claims

| Place of search | Date of completion of the search | Examiner |
|---|---|---|
| Munich | 28 July 2006 | Ratajski, A |

EPO FORM 1503 03.82 (P04C01)

## ANNEX TO THE EUROPEAN SEARCH REPORT
## ON EUROPEAN PATENT APPLICATION NO.

EP 06 29 0067

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2006

| Patent document cited in search report | | Publication date | Patent family member(s) | | Publication date |
|---|---|---|---|---|---|
| US 2002150169 | A1 | 17-10-2002 | KR | 2002081542 A | 28-10-2002 |
| US 2002048325 | A1 | 25-04-2002 | JP | 2002111760 A | 12-04-2002 |
| | | | KR | 2002023125 A | 28-03-2002 |
| US 5548244 | A | 20-08-1996 | NONE | | |
| EP 1213830 | A | 12-06-2002 | AT | 249108 T | 15-09-2003 |
| | | | AU | 2355102 A | 18-06-2002 |
| | | | CN | 1479967 A | 03-03-2004 |
| | | | DE | 60005030 D1 | 09-10-2003 |
| | | | DE | 60005030 T2 | 01-04-2004 |
| | | | WO | 0247247 A1 | 13-06-2002 |
| | | | JP | 2004526343 T | 26-08-2004 |
| | | | US | 2004037379 A1 | 26-02-2004 |

EPO FORM P0459

For more details about this annex : see Official Journal of the European Patent Office, No. 12/82